# EUROPEAN PATENT APPLICATION

(11) **EP 4 593 539 A1**
(43) Date of publication of application: **30.07.2025**
(21) Application number: 23867605.0
(22) Date of filing: 21.09.2023
(51) Int. Cl.: H05K 7/20, H01R 13/514

(54) **CONNECTOR HAVING COOLING MODULE**

(30) Priority: 21.09.2022 CN 202211150042
(71) Applicant: Changchun Jetty Automotive Technology Co., Ltd., Changchun City, Jilin Province 130000 (CN)
(72) Inventor: WANG, Chao, Changchun, Jilin 130000 (CN)
(74) Representative: Boult Wade Tennant LLP
(86) International application number: PCT/CN2023/120415
(87) International publication number: WO 2024/061320

(57) **Abstract**

The present disclosure relates to a connector (100) having a cooling module, including a connector housing (1) and a cooling module. An electric connecting device (2) is disposed in the connector housing (1). The cooling module includes a phase change material unit (5) capable of absorbing or releasing heat by means of phase change, and the phase change material unit (5) is disposed in the connector housing (1). when the connector (100) having the cooling module is in operation, the phase change material unit (5) absorbs heat generated by the electrical connection device (2) by means of phase change. After the connector (100) having the cooling module stops operation, the phase change material unit (5) releases heat by means of phase change. In the present disclosure, the phase change material unit (5) is provided inside to absorb, by means of phase change, the heat generated by the connector during operation, and releases heat by means of phase change when the connector is not in operation, thereby achieving the purpose of cooling.

## Description

### CROSS-REFERENCE TO RELATED APPLICATION

The present disclosure claims priority to Chinese Invention Patent Application No. 202211150042.4, entitled "connector with cooling module", and filed on September 21, 2022.

### TECHNICAL FIELD

The present disclosure relates to the technical field of connectors, and particularly to a connector with a cooling module.

### BACKGROUND

In high-power fast charging for electric vehicles, with the improvement of the charging efficiency and the increase of the current, more heat is generated, which leads to the temperature rise in the components. The continuous temperature rise may affect the functionality and the safety of the components, thereby causing damages to the components, and the generated heat becomes a resistance that limits the high-power charging system. For the high-power fast charging, it is necessary to add a cooling system to a connector.

Therefore, based on years of experience and practice in related industries, the inventor proposes a connector having a cooling module to overcome the defects of the prior art.

### SUMMARY

The present disclosure aims to provide a connector having a cooling module, in which a phase change material unit is disposed; the phase change material unit absorbs, by means of phase change, heat generated by the connector during operation, and releases heat by means of phase change when the connector is not in operation, thereby achieving the purpose of cooling.

The objective of the present disclosure is achieved by a connector having a cooling module, including a connector housing and a cooling module. An electrical connection device is disposed in the connector housing, the cooling module includes a phase change material unit capable of absorbing or releasing heat by means of phase change, and the phase change material unit is disposed in the connector housing. When the connector having the cooling module is in operation, the phase change material unit absorbs, by means of phase change, heat generated by the electrical connection device. After the connector having the cooling module stops operation, the phase change material unit releases heat by means of phase change.

As can be seen from the above description, the connector having the cooling module of the present disclosure has the following advantageous effects:

In the connector having the cooling module according to the present disclosure, the cooling module including the phase change material unit is disposed in the connector housing. The cooling module absorbs heat generated by the connector during operation through the phase change material. After the temperature of the connector rises, the cooling module releases heat through the phase change material to achieve the purpose of cooling.

In the connector having the cooling module according to the present disclosure, the heat released by the phase change material unit is more quickly dissipated to the outside of the connector housing through the heat dissipation structure that may adopt various forms, so that the heat dissipation mode is flexible. The heat released by the phase change of the phase change material unit may be dissipated to the outside of the connector housing as soon as possible through the cooling fins, the cooling channels and/or the heat-conductive polymers, so as to improve the heat dissipation efficiency.

### BRIEF DESCRIPTION OF THE DRAWINGS

For a clearer illustration of technical features in the embodiments of the present disclosure, a brief description of the drawings for the embodiments will be given below. The drawings described below involve only some embodiments of this disclosure. For those of ordinary skill in the art, other drawings can be derived from these drawings without any inventive efforts. In the drawings:
FIG. 1 illustrates an isometric view of a connector having a cooling module according to a first embodiment of the present disclosure.
FIG. 2 illustrates a front view of the connector having a cooling module according to the first embodiment of the present disclosure with a back cover removed.
FIG. 3 illustrates an isometric view of a connector having a cooling module according to a second embodiment of the present disclosure.
FIG. 4 illustrates an isometric view of a back cover of the present disclosure.
FIG. 5 illustrates a side view of a back cover of the present disclosure.
FIG. 6 illustrates a cross-sectional view taken along line A-A in FIG. 5.
FIG. 7 illustrates an isometric view of a connector having a cooling module according to a third embodiment of the present disclosure with a back cover removed.
FIG. 8 illustrates a front view of a connector having a cooling module according to a third embodiment of the present disclosure with a back cover removed.
FIG. 9 illustrates a cross-sectional view taken along Line B-B in FIG. 8.

### DETAILED DESCRIPTION OF THE EMBODIMENTS

For a clearer understanding of the technical features, objectives and effects of the present disclosure, specific embodiments of the present disclosure will now be described with reference to the drawings.

The specific embodiments of the present disclosure described here are only for the purpose of explaining the present disclosure, and cannot be understood as limitations to the present disclosure in any way. Being taught by the present disclosure, a skilled person can conceive any possible variation based on the present disclosure, which should be regarded as falling within the scope of the present disclosure. It should be noted that when an element is referred to as being 'disposed' on another element, it may be directly on another element or there may be an intermediate element. When an element is regarded as being 'connected' to another element, it may be directly connected to another element or there may be an intermediate element at the same time. The terms 'mount' and 'connect' should be understood in a broad sense. For example, a connection may be a mechanical connection or an electrical connection, or an internal communication between two elements, or a direct connection, or an indirect connection through an intermediate medium. For persons of ordinary skills in the art, the specific meanings of the above terms can be understood according to the specific conditions. The terms 'vertical', 'horizontal', 'upper', 'lower', 'left', 'right' and similar expressions used herein are for an illustration purpose only rather than indicating a unique embodiment.

Unless otherwise defined, all technical and scientific terms used herein have the same meanings as those commonly understood by those skilled in the art of the present disclosure. The terms used in the Specification of the present disclosure are only for the purpose of describing the specific embodiments, rather than limiting the present disclosure. The term "and/or" used herein includes any and all combinations of one or more of the associated items listed.

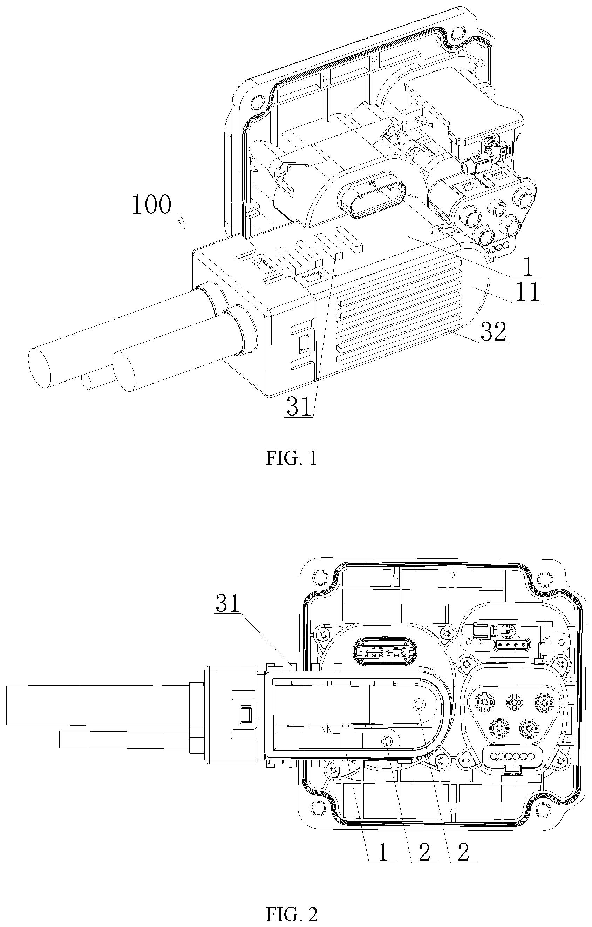

As illustrated in FIGS. 1 to 7, the present disclosure provides a connector 100 having a cooling module, including a connector housing 1 and a cooling module. The connector housing 1 is internally provided with one or more electrical connection devices 2. In a specific embodiment of the present disclosure, the number of the electrical connection devices 2 is two. The electrical connection device 2 is a current or data transmission device that connectable to at least one current transmission source or pulse transmission source, and is disposed in a transmission device housing and provided with a contact element. In a specific embodiment of the present disclosure, the electrical connection device 2 is a terminal, which may be a block terminal or a cable terminal and made of a soft or hard material, and the specific model of the terminal may be determined according to the actual use requirements.

The cooling module includes a phase change material unit 5 capable of absorbing or releasing heat by means of phase change, and the phase change material unit 5 is disposed in the connector housing 1. When the connector 100 having the cooling module is in operation, the phase change material unit absorbs heat generated by the electrical connection device 2 by mean of phase change (when the connector 100 having the cooling module is in operation, the electrical connection device 2 is conducted with a corresponding circuit to generate heat). After the connector 100 having the cooling module stops operation, the phase change material unit releases heat better by means of phase change.

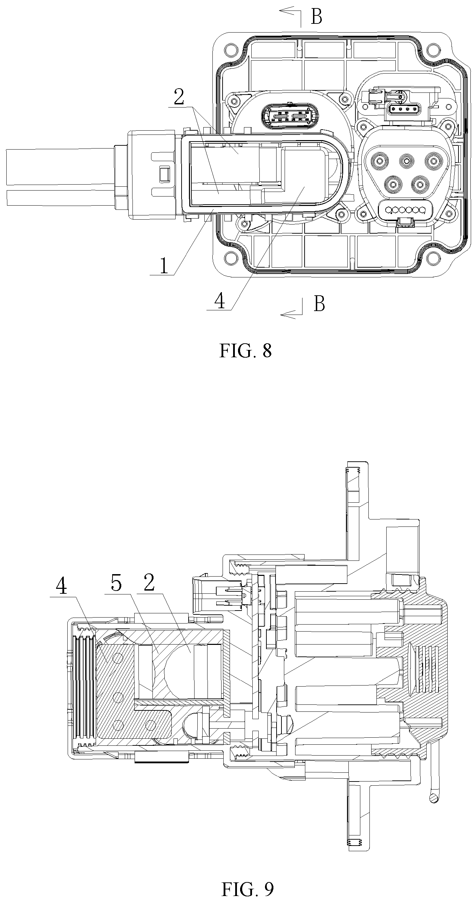

As illustrated in FIG. 9, the phase change material unit 5 is filled in the connector housing 1 to fill up gaps inside the connector housing 1. The phase change material unit may be a solid-liquid phase change material, such as an organic mixed alkane, which has a phase change temperature of 36°C, a latent heat of 220 KJ/Kg, a density of 0.8 Kg/m³, a maximum service temperature of 300°C, and a good insulation and no corrosiveness, and the volume of the liquid phase is 10% smaller than that of the solid phase. The basic principle is that when the temperature changes, the phase change material generally changes from one state into another state, and absorbs and releases a lot of heat in a process of changing between different phases. This process is reversible, so that the material can be reused for many times, with the advantages of a large phase change latent heat, a wide phase change temperature range and low cost. When the temperature is low, internal energy of the substance of the phase change material is low, constraints between molecules are large, and even in a free state, the motion range of molecules is very narrow, so that the material is in a solid state, forming an ordered structure with the lowest potential energy. In this state, the interaction force between molecules is the strongest, firmly bounding the molecules in place. When the temperature rises, the phase change material absorbs a lot of heat, the internal energy of the substance is increased, the constraints between molecules are relaxed, and the motion range of molecules in the free state are greatly extended, because the molecules move violently enough and some molecules always stay in potential wells restlessly. The bonds between molecules are always broken and connected quickly, causing molecules to slide relative to each other. However, these motions are not violent enough for molecules to escape from the interaction and become free molecules. As a result, the molecules gather by twos and threes into clusters. Due to the continuous collision of molecules, the molecular clusters will present a process of gathering-breaking up-regathering, thereby forming a flowing state and producing a phase change. By absorbing heat generated by the connector during operation through a solid-liquid phase change process, the solid-liquid phase change material changes from a solid state to a liquid state. When the connector is not in operation, the solid-liquid phase change material releases heat and changes from a liquid state to a solid state.

The phase change material unit may also be a solid-solid phase change material, or a mixture of solid-liquid and solid-solid phase change materials.

In the connector having the cooling module according to the present disclosure, the cooling module including the phase change material unit is disposed inside the connector housing, the cooling module absorbs heat generated by the connector during operation through the phase change material, and after the temperature of the connector rises, the cooling module conducts heat through the phase change material to achieve the purpose of cooling.

Further, the connector 100 having the cooling module also includes a heat dissipation structure, through which the heat released by the phase change of the phase change of the phase change material unit is more quickly dissipated to the outside of the connector housing.

The heat dissipation structure may adopt a heat dissipation mode by disposing cooling fins on the connector housing, or disposing cooling channels in the connector housing, or disposing heat-conductive polymers on the connector housing, or a combination thereof.

Further, when the heat dissipation structure of the connector 100 having the cooling module adopts a cooling fin heat dissipation mode, the phase change material unit generally adopts a solid-solid phase change material. As illustrated in FIGS. 1 and 2, the heat dissipation structure includes a first cooling fin group 31 disposed on an outer wall of the connector housing 1, and the first cooling fin group 31 may include a plurality of metal or non-metal cooling fins. The heat released by the phase change material unit by means of phase change is quickly dissipated by the first cooling fin group 31 to achieve the purpose of cooling.

The metal cooling fins may be made of aluminum alloy, and the non-metal cooling fins may be made of heat-conductive plastic, which is a novel high-performance plastic formed by using general plastic or engineering plastic as a base material, and blending and compounding a high-heat-conductivity composite material with the plastic base material for being modified through heat conduction. The main base materials include PPS, PA6/PA66, LCP, TPE, PC, PP, PPA, PEEK, etc. The main fillers include AlN, SiC, Al₂O₃, Mg(OH)₂, graphite, etc. The heat-conductive plastics have several advantages: 1) insulation, flame retardancy and high reliability; 2) convenient processing and formation, and good mass production; 3) no secondary processing is needed, which is more environmentally friendly; and 4) light weight, and the density is about two-thirds of aluminum.

The housing 1 may be made of aluminum alloy or heat-conductive plastic, the cooling fins and the housing may be integrally machined or may be bonded together. The aluminum alloy may be cast or the heat-conductive plastic may be integrally injected. If the cooling fins are made of metal, injection molding may also be carried out in an embedded way.

The housing 1 and the cooling fins may adopt a way of double-color injection molding. The shell 1 is made of common plastic, and the cooling fins are made of heat-conducting plastic, so as to reduce the processing cost.

As illustrated in FIGS. 1, 3, 4 and 5, in a first embodiment of the present disclosure, one side of the connector housing 1 is provided with an opening, to which a back cover 11 is detachably connected. A second cooling fin group 32 is disposed on an outer side of the back cover 11, and the second cooling fin group 32 includes a plurality of metal or non-metal cooling fins. The second cooling fin group 32 may be made of the same material as the first cooling fin group 31. The metal cooling fins may be made of aluminum alloy and the non-metal cooling fins may be made of heat-conductive plastic. The second cooling fin group 32 and the first cooling fin group 31 dissipate heat together, which further improves the heat dissipation effect and is beneficial to faster heat dissipation of the connector.

Further, when the heat dissipation structure of the connector 100 having the cooling module adopts a cooling channel heat dissipation mode, it is generally used in conjunction with the aforementioned cooling fins. In this heat dissipation mode, the phase change material unit is generally a solid-solid phase change material or a solid-liquid phase change material, or a mixture of solid-liquid and solid-solid phase change materials.

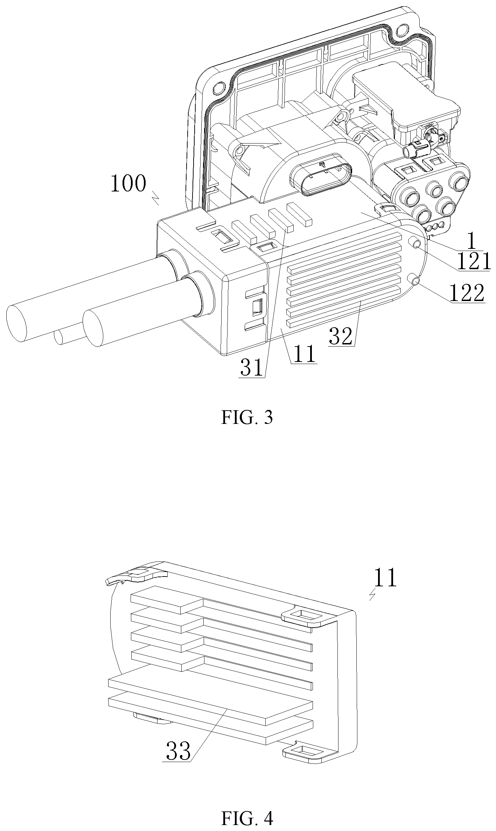

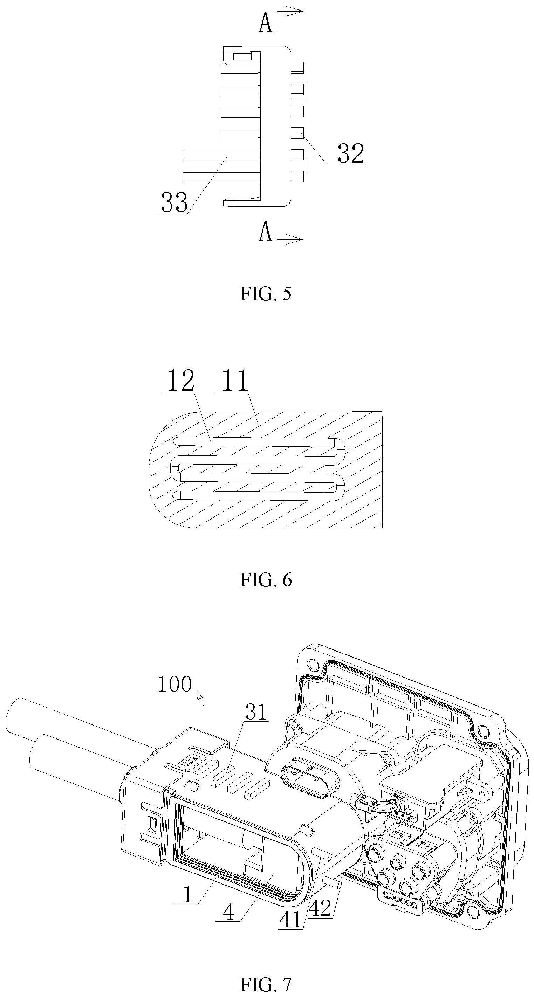

As illustrated in FIGS. 3 and 6, in a second embodiment of the present disclosure, the heat dissipation structure includes a first cooling channel 12 disposed in the back cover 11. An inlet 121 and an outlet 122 of the first cooling channel are both located on an outer side of the back cover 11. The first cooling channel 12 may be a liquid-cooling channel or an air-cooling channel.

In this heat dissipation mode, a third cooling fin group 33 may be disposed on an inner side of the back cover 11 to better conduct heat, and the third cooling fin group 33 includes a plurality of metal cooling fins. The heat is conducted to the phase change material unit (solid-liquid phase change material, etc.) through the electrical connection device 2, and the phase change material unit absorbs the heat and undergoes a phase change, while conducting the heat to the back cover 11 through the third cooling fin group 33 disposed on an iner side of the back cover. Finally, the heat is released through the first cooling channel 12 in the back cover 11 and the second cooling fin group 32 on the outer side of the back cover 11.

Further, when the heat dissipation structure of the connector 100 having the cooling module adopts a cooling channel heat dissipation mode, as illustrated in FIGS. 7, 8 and 9, in a third embodiment of the present disclosure, the heat dissipation structure may further include a conductive structure 4 disposed in the connector housing 1, a second cooling channel is disposed in the conductive structure 4, and an inlet 41 and an outlet 42 of the second cooling channel are both located on an outer side of the connector housing 1. The second cooling channel may be a liquid-cooling channel or an air-cooling channel.

The heat is conducted to the phase change material unit (solid-liquid phase change material, etc.) through the electrical connection device 2, and the phase change material unit absorbs the heat and undergoes a phase change, while conducting the heat to the conductive structure 4. Finally, the heat is released through the second cooling channel in the conductive structure 4.

The above two kinds of heat dissipation structures operate on the same principle: they utilize a cooling medium flowing rapidly through cooling channels to carry away heat. The fluid in the cooling channel may be liquid or gaseous. This principle accelerates the cooling of the phase change material unit (solid-liquid phase change material, etc.), thereby providing better cooling for the connector.

Further, when the heat dissipation structure of the connector 100 having the cooling module adopts a heat-conductive-polymer heat dissipation mode, the heat dissipation structure includes a first heat-conductive polymer part disposed on an inner side of the back cover 11. Generally, the heat-conductive polymer is filled by means of injection, with a heat conductivity much higher than that of air, thereby effectively improving the heat dissipation efficiency.

In this heat dissipation mode, the heat dissipation structure may also include a second heat-conductive polymer part disposed on an outer side of the connector housing and configured to accelerate the dissipation of the heat released by the phase change of the phase change material unit.

As can be seen from the above description, the connector having the cooling module according to the present disclosure has the following advantageous effects:

In the connector having the cooling module according to the present disclosure, the cooling module including the phase change material unit is disposed in the connector housing. The cooling module absorbs heat generated by the connector during operation through the phase change material. After the temperature of the connector rises, the cooling module releases heat through the phase change material to achieve the purpose of cooling.

In the connector having the cooling module according to the present disclosure, the heat released by the phase change material unit is more quickly dissipated to the outside of the connector housing through the heat dissipation structure that may adopt various forms, so that the heat dissipation mode is flexible. The heat released by the phase change of the phase change material unit may be dissipated to the outside of the connector housing as soon as possible through the cooling fins, the cooling channels and/or the heat-conductive polymers, so as to improve the heat dissipation efficiency.

Those described above are merely illustrative of specific embodiments of the present disclosure, and are not intended to limit the scope of the present disclosure. Any equivalent change or modification made by persons skilled in the art without departing from the concept and the principle of the present disclosure should fall within the protection scope of the present disclosure.

## Claims

1. A connector having a cooling module, comprising a connector housing and a cooling module, wherein an electrical connection device is disposed in the connector housing, the cooling module comprises a phase change material unit capable of absorbing or releasing heat by means of phase change, and the phase change material unit is disposed in the connector housing;
the phase change material unit absorbs, by means of phase change, heat generated by the electrical connection device when the connector having the cooling module is in operation, and releases heat by means of phase change after the connector having the cooling module stops operation.

2. The connector having the cooling module according to claim 1, wherein the phase change material unit comprises a solid-liquid phase change material, or a solid-solid phase change material, or a mixture of solid-liquid and solid-solid phase change materials.

3. The connector having the cooling module according to claim 1 or 2, wherein the phase change material unit fills up gaps inside the connector housing.

4. The connector having the cooling module according to claim 1, further comprising a heat dissipation structure, through which the heat released by the phase change of the phase change material unit is dissipated to the outside of the connector housing.

5. The connector having the cooling module according to claim 4, wherein the heat dissipation structure comprises a first cooling fin group disposed on an outer wall of the connector housing.

6. The connector having the cooling module according to claim 5, wherein one side of the connector housing is provided with an opening, to which a back cover is detachably connected, and the heat dissipation structure further comprises a second cooling fin group disposed on an outer side of the back cover.

7. The connector having the cooling module according to claim 6, wherein the heat dissipation structure further comprises a first cooling channel disposed in the back cover, and an inlet and an outlet of the first cooling channel are both located on the outer side of the back cover.

8. The connector having the cooling module according to claim 7, wherein the first cooling channel is a liquid-cooling channel or an air-cooling channel.

9. The connector having the cooling module according to claim 7, wherein the heat dissipation structure further comprises a third cooling fin group disposed on an inner side of the back cover.

10. The connector having cooling module according to claim 7, wherein the heat dissipation structure further comprises a first heat-conductive polymer part disposed on an inner side of the back cover.

11. The connector having the cooling module according to claim 4, 5 or 6, wherein the heat dissipation structure comprises a conductive structure disposed in the connector housing, a second cooling channel is disposed in the conductive structure, and an inlet and an outlet of the second cooling channel are both located on an outer side of the connector housing.

12. The connector having the cooling module according to claim 11, wherein the second cooling channel is a liquid-cooling channel or an air-cooling channel.

13. The connector having the cooling module according to claim 4, wherein the heat dissipation structure comprises a second heat-conductive polymer part disposed on an outer side of the connector housing for accelerating the dissipation of the heat released by the phase change of the phase change material unit.
